# FASCICULE DE BREVET EUROPEEN

(11) **EP 2 452 430 B1**
(45) Date de publication et mention de la délivrance du brevet: **27.11.2013**
(21) Numéro de dépôt: 10731512.9
(22) Date de dépôt: 07.07.2010
(51) Int. Cl.: H03F 1/26, H03F 3/189, H04B 1/10

(54) **AMPLIFICATEUR FAIBLE BRUIT DOUBLE PERFORMANCE POUR COMMUNICATION RADIOFRÉQUENCE PAR SATELLITE**
RAUSCHARMER VERSTÄRKER FÜR FUNKKOMMUNICATION ÜBER SATELLIT
LOW NOISE AMPLIFIER FOR RADIO-FREQUENCY COMMUNICATION BY SATELLITE

(30) Priorité: 08.07.2009 FR 0954739
(43) Date de publication de la demande: 16.05.2012
(73) Titulaire: Callisto France, 31290 Villefranche de Lauragais (FR)
(72) Inventeur: RAWSON, Stephen, F-11320 Labastide d'Anjou (FR); FAUROUX, Benoît, F-11400 Castelnaudary (FR); RAYET, Rémi, F-31400 Toulouse (FR); BONHOURE, Thomas, F-31290 Avignonet Lauragais (FR); CHAMBON, Cédric, F-31290 Villefranche Lauragais (FR)
(74) Mandataire: Fourcade, Emmanuelle
(86) Numéro de dépôt international: PCT/EP2010/059693
(87) Numéro de publication internationale: WO 2011/003929

(56) Documents cités:
- EP-A2- 1 014 480
- US-A- 6 104 934
- ROBERT R ROMANOFSKY ET AL: "A Cryogenic K-Band Ground Terminal for NASA'S Direct-Data-Distribution Space Experiment", IEEE TRANSACTIONS ON MICROWAVE THEORY AND TECHNIQUES, IEEE SERVICE CENTER, PISCATAWAY, NJ, US, vol. 48, no. 7, 1 juillet 2000 (2000-07-01), XP011038022, ISSN: 0018-9480
- ALINA C ET AL: "Characterization techniques for temperature-dependent experimental analysis of microwave transistors", IMTC 2001. PROCEEDINGS OF THE 18TH. IEEE INSTRUMENTATION AND MEASUREMENT TECHNOLOGY CONFERENCE. BUDAPEST, HUNGARY, MAY 21 - 23, 2001; [IEEE INSTRUMENTATION AND MEASUREMENT TECHNOLOGY CONFERENCE. (IMTC):], NEW YORK, NY : IEEE, US, vol. 3, 21 mai 2001 (2001-05-21), pages 1893-1896, XP010547280, ISBN: 978-0-7803-6646-6

## Description

La présente invention appartient au domaine des équipements mis en oeuvre pour la communication entre des satellites, de manière générale des objets spatiaux, et des stations terrestres fixes ou mobiles.

Plus particulièrement l'invention concerne un amplificateur faible bruit et hautes fréquences utilisé dans une chaîne de réception des signaux satellites.

L'invention concerne également un procédé de mise en oeuvre de l'amplificateur de l'invention pour améliorer la qualité des communications entre un satellite ou un objet spatial et une station terrestre.

Aujourd'hui les communications entre le sol et les objets évoluant hors de l'atmosphère dense, les satellites et les objets spatiaux en général, sont réalisées presque exclusivement par des signaux radiofréquences et en raison de l'augmentation croissante de la demande en canaux et en bande passante, il est fait usage de fréquences de plus en plus élevées.

En raison de l'encombrement des bandes radiofréquences actuellement utilisées pour les communications avec les satellites, les bandes L, S, C et Ku, et de la réservation de la bande X à des applications militaires, il est devenu très difficile d'obtenir de nouvelles allocations de canaux dans les fréquences allant de 1 GHz à 18 GHz, fréquences qui sont couvertes par ces bandes.

Les systèmes de liaison avec les satellites s'orientent donc vers l'usage des fréquences encore plus élevées de 18 GHz à 40 GHz des bandes K et Ka.

Ces bandes de fréquences élevées mises en oeuvre pour ces communications présentent des avantages réels.

L'élévation des fréquences autorise des bandes passantes plus élevées et donc facilite les services dédiés à large bande qui exigent de transmettre beaucoup de données comme la téléphonie, la vidéoconférence, la télévision numérique, en particulier haute définition, l'internet par satellite ...

Les bandes K et Ka qui sont actuellement peu utilisées permettent en outre d'obtenir des allocations de canaux sans difficultés particulières.

Les fréquences élevées permettent aussi de réaliser des antennes plus petites pour un gain donné ce qui est avantageux dans de nombreuses circonstances, en particulier pour les installations mobiles ou devant rester discrètes comme les installations militaires, sans être dénuées d'intérêts pour les installations fixes en réduisant les dimensions des infrastructures.

Cette réduction des dimensions des antennes est aussi un avantage dans le cas de la poursuite des objets spatiaux ou en phase de lancement.

Cependant les phases critiques : lancement, mise en orbite, orbite de parking... exigent une garantie de qualité de la liaison qui conduit à utiliser des antennes de poursuite de grandes tailles dont le contrôle du pointage est complexe non seulement en raison de la taille mais également en raison de leurs grandes directivités.

L'augmentation des fréquences pour les communications n'est cependant pas sans inconvénient car les signaux hautes fréquences en général et encore plus dans les bandes de fréquences K, Ka sont sensibles aux phénomènes atmosphériques.

En pratique les conditions de propagation se dégradent en fonction des caractéristiques atmosphériques locales dans laquelle se trouve une antenne de réception, en particulier l'humidité de l'air, la présence de nuages ou de pluie, et les signaux s'en trouvent affaiblis.

Dans les cas les plus défavorables les signaux d'un satellite ne peuvent plus être reçus de manière intelligible et le système de communication n'est plus disponible.

Afin de palier à ces difficultés et pour maintenir les communications avec les satellites et autres objets spatiaux plusieurs solutions sont aujourd'hui mises en oeuvre.

Une première solution consiste à maintenir la communication en augmentant la puissance de l'émetteur lorsque les conditions de transmission se dégradent pour contrer l'atténuation introduite par les mauvaises conditions de propagation. Relativement simple à mettre en oeuvre lorsqu'elle a été prévue au niveau de l'émetteur lors de sa conception, cette solution provoque cependant l'apparition d'interférences et augmente rapidement le taux d'intermodulation ce qui en limite les possibilités d'utilisation.

Une autre solution consiste à adapter le signal transmis et à réduire le débit pour adapter le bilan de liaison. Cette solution est cependant relativement complexe à mettre en oeuvre, manque de réactivité et surtout implique une baisse du débit qui peut être incompatible avec le service attendu.

D'autres solutions sont basées sur une technique de re-routage de la transmission soit par une autre station sol, soit par un satellite relais, qui permet de s'affranchir des contraintes locales où les conditions de transmission entre le sol et le satellite sont défavorables.

Ces solutions sont très efficaces puisqu'elles permettent de restituer la communication avec toutes les performances initiales, mais elles sont complexes et d'un coût élevé car exigeant une redondance de moyens.

Ces différentes solutions peuvent le cas échéant être combinées entre elles et également à l'amélioration propre de la performance des composants d'une chaîne de réception, en particulier la dimension des antennes ainsi que la sensibilité et le rapport signal sur bruit des récepteurs.

Ainsi il est connu de refroidir les amplificateurs pour en améliorer le rapport signal sur bruit en réduisant le bruit interne des amplificateurs.

Les composants du récepteur radiofréquence, amplificateurs, filtres ..., sont dans ces cas associés à des générateurs cryogéniques permettant de maintenir dans une enceinte isolante telle qu'un Dewar (du nom de l'inventeur) les composants en question à une très basse température, dans le domaine de radiocommunications courantes le plus souvent à une température de l'ordre de 100 Kelvin voire inférieure.

Des exemples d'amplificateur faible bruit de radiofréquence où un cryostat est utilisé pour réfrigérer l'amplificateur afin d'améliorer le rapport signal sur bruit peuvent être trouvées dans les documents de brevet US 6,104,934 et EP 1,014,480 et dans Romanofsky et al., "A Cryogenic K-Band Ground Terminal for NASA'S Direct-Data-Distribution Space Experiment" (IEEE Transactions On Microwave Theory and Techniques, 2000) et Alina et al., "Characterization techniques for temperature-dependent experimental analysis of microwave transistors" (IMTC 2001. Proceedings of the 18th. IEEE Instrumentation and Measurement Technology Conference. Budapest, Hungary, May 21 - 23, 2001).

Dans les systèmes connus, les composants, y compris l'antenne, sont conçus pour que leurs performances nominales répondent aux situations les plus critiques pouvant être rencontrées en utilisation et pour lesquelles les communications doivent être maintenues.

Les conditions entraînant une dégradation des conditions de propagation étant généralement localisée et temporaire, il en résulte que les systèmes présentent des performances largement supérieures aux besoins pendant la plus grande partie de leur durée d'utilisation.

L'augmentation résultante de la complexité des composants et de leur maintien dans un état opérationnel se traduit par une augmentation sensible de leurs coûts de fabrication et d'utilisation et par une diminution de leurs fiabilités.

Afin de palier à ces difficultés l'invention propose de réaliser un amplificateur à faible bruit comportant deux modes de fonctionnement, l'un dit normal à température ambiante et l'autre dit amélioré à très basses températures et comportant des caractéristiques propres qui rendent le dit amplificateur à faible bruit de l'invention apte à fonctionner en mode alterné.

L'amplificateur faible bruit de l'invention destiné à être mis en oeuvre dans un dispositif de réception d'un signal radiofréquence d'un satellite, ou de manière générale d'un objet spatial, comporte un amplificateur, en tant que composant électronique, maintenu dans une cavité étanche délimitée par la paroi d'un cryostat, et comporte un réfrigérateur cryogénique fixé à l'extérieur du cryostat au niveau d'une face de la paroi du cryostat.

L'amplificateur est :
- maintenu dans la cavité étanche solidaire, directement ou par l'intermédiaire d'un substrat sur lequel est placé l'amplificateur, de la surface de pose située à l'extrémité d'un doigt froid du réfrigérateur cryogénique, la surface de pose du doigt froid étant réalisée dans un matériau bon conducteur de la chaleur et le doigt froid traversant sans contact direct la paroi du cryostat;
- relié à un coupleur d'entrée au niveau d'une entrée de l'amplificateur et à un coupleur de sortie au niveau d'une sortie de l'amplificateur qui traversent chacun la paroi du cryostat;
- fonctionnel d'une part à une température ambiante autour de 288 Kelvin, en pratique la température régnant à la surface de la Terre à l'emplacement du dispositif de réception, et au moins à une température cryogénique déterminée très inférieure à la température ambiante;
et la cavité étanche du cryostat contient, au moins pendant le fonctionnement à température cryogénique, un gaz à une pression comprise entre une pression voisine de la pression à l'extérieur du cryostat et une pression d'environ 0,1 millibar.

Ainsi l'amplificateur faible bruit est en mesure d'être réalisé avec des dimensions réduites, malgré le nécessaire réfrigérateur cryogénique, tout en présentant au moins deux modes de fonctionnement, dont l'un sans faire fonctionner le réfrigérateur cryogénique consommateur d'énergie et dont l'utilisation diminue la fiabilité de l'amplificateur faible bruit, et sans faire de compromis sur le bilan de liaison avec le satellite.

Dans une forme de réalisation le coupleur d'entrée comporte un guide d'onde fixé à une extrémité intérieure au niveau de l'entrée de l'amplificateur et à une extrémité extérieure au niveau d'une traversée étanche de la paroi du cryostat et ceci sans discontinuité électrique entre l'entrée de l'amplificateur et une interface de raccordement d'une antenne de réception au niveau d'une fenêtre guide d'onde, le coupleur de sortie comportant un guide d'ondes agencé de manière similaire au niveau de la sortie de l'amplificateur.

Dans une autre forme de réalisation, le coupleur d'entrée comporte un câble coaxial entre l'entrée de l'amplificateur et une prise coaxiale traversant de manière étanche la paroi du cryostat et le coupleur de sortie comporte de manière similaire un câble coaxial entre la sortie de l'amplificateur et une prise coaxiale traversant de manière étanche la paroi du cryostat.

Dans une forme préférée avantageusement adaptée aux signaux d'entrée et de sortie, le coupleur d'entrée comporte un guide d'onde, fixé à une extrémité intérieure au niveau de l'entrée de l'amplificateur et à une extrémité extérieure au niveau d'une traversée étanche de la paroi du cryostat sans discontinuité électrique entre l'entrée de l'amplificateur et une interface de raccordement d'une antenne de réception au niveau d'une fenêtre guide d'onde, et le coupleur de sortie comporte un câble coaxial entre la sortie de l'amplificateur et une prise coaxiale traversant de manière étanche la paroi du cryostat.

Dans tous les cas où un guide d'ondes est mis en oeuvre pour réaliser un coupleur, afin de limiter les transferts d'énergie thermique entre l'intérieur et l'extérieur du cryostat, le ou les guides d'ondes sont constitués principalement d'un matériau métallique à faible conductivité thermique, de préférence inférieure à 50W/m.K, et comporte, afin d'obtenir les performances optimales de transmission radioélectrique, au niveau d'une surface intérieure de la cavité du guide d'ondes un dépôt mince d'un matériau de conductivité électrique élevée, de préférence supérieure à 40 10E6 Siemens/m.

Avantageusement le matériau métallique à faible conductivité thermique est un acier inoxydable ou un alliage fer-nickel comportant environ 36% de nickel tel que de l'Invar® et le matériau de conductivité électrique élevée est de l'argent, du cuivre ou de l'or.

Dans une autre forme de réalisation afin de réduire au maximum les conductions thermiques entre la cavité intérieure du cryostat et l'extérieur, au moins un coupleur traverse la paroi (21) par une ouverture ou iris (212) au niveau de la paroi (211) d'un guide d'ondes (56, 66) et comporte une ligne micro-ruban comportant :
- un micro-ruban en matériau électriquement conducteur;
- le micro-ruban étant solidaire d'un film diélectrique mince sur une face supérieure dudit film diélectrique;
- le film diélectrique mince comportant une couche métallisée sur une face inférieure à l'opposée de la face supérieure et formant un plan de masse électrique;
- la ligne micro-ruban s'étendant au niveau d'une première extrémité, l'extrémité libre, dans le guide d'onde en traversant la paroi du guide d'onde par l'iris, sans qu'il y ait de contact métallique entre la ligne micro-ruban et la paroi du guide d'onde;
- la ligne micro-ruban s'étendant au niveau d'une seconde extrémité, l'extrémité intérieure, à l'opposé de l'extrémité libre sur la ligne micro-ruban, jusqu'à proximité de l'amplificateur sans contact direct avec l'amplificateur ;
- la ligne micro-ruban étant dépourvue de la couche métallisée dans la partie de cette ligne micro-ruban située à l'intérieur du guide d'onde.

Pour maintenir mécaniquement la ligne micro-ruban à la position qu'elle doit occuper dans l'amplificateur faible bruit, cette ligne micro-ruban est maintenue, au niveau de l'iris dans la paroi du guide d'onde, en appui sur une semelle d'un matériau hautement diélectrique pour ne pas altérer le fonctionnement de la ligne micro-ruban, proche de celui d'une antenne.

Pour assurer la tenue mécanique de la ligne micro-ruban, formée d'un ensemble de matériaux métalliques et diélectriques minces, la ligne micro-ruban est solidaire d'un bras support sur lequel elle est fixée.

Pour que le bras support s'étende sur la plus grande longueur possible de la ligne micro-ruban sans perturber le fonctionnement radioélectrique et thermique de l'amplificateur faible bruit, le bras support est solidaire d'un support de l'amplificateur à proximité de l'extrémité intérieure de la ligne micro-ruban et il est interrompu du côté de l'extrémité libre de la ligne micro-ruban avant cette extrémité libre de telle sorte à être maintenu proche de la paroi du guide d'onde pour soutenir la ligne micro-ruban sur la plus grande longueur possible, mais sans contact avec la paroi du guide d'onde pour éviter de créer des ponts thermiques.

L'extrémité intérieure du coupleur opposée à l'extrémité libre est située proche de l'amplificateur et sans contact direct avec l'amplificateur au niveau duquel le micro-ruban de la ligne micro-ruban est relié par un fil de connexion.

Lorsqu'un tel coupleur à ligne micro-ruban est mis en oeuvre, pour l'un des coupleurs, l'autre coupleur peut être du même type ou d'une des autres formes possibles envisagées, i.e. à guide d'ondes ou à câble coaxial.

Pour améliorer la qualité de l'isolation thermique et diminuer autant que possible la taille et la consommation du réfrigérateur cryogénique, la cavité étanche est avantageusement remplie d'un matériau isolant thermique, par exemple un matériau ayant de bonnes propriétés d'isolation comme un matériau nanostructuré qui peut être réalisé à base de silice tel qu'un aérogel de silice qui se présente entre autre sous forme de micro-billes ou de feuilles.

Les nécessaires connexions électriques pour assurer le fonctionnement de l'amplificateur et son contrôle traversent la paroi du cryostat de sorte que l'étanchéité de la cavité étanche du cryostat est assurée, en particulier au moyen de connecteurs étanches.

Toujours dans le but de diminuer les contraintes de refroidissement dans le mode de fonctionnement cryogénique, la consommation d'énergie et les dimensions de l'amplificateur à faible bruit sont avantageusement réduites en réalisant l'amplificateur suivant une technologie de circuit intégré micro-ondes monolithique.

Pour un bon refroidissement de l'amplificateur la surface de pose du doigt froid est de préférence réalisée en cuivre ou dans un alliage à base de cuivre et pour atteindre un niveau de bruit interne de l'amplificateur suffisamment faible, le réfrigérateur cryogénique est réalisé pour délivrer au niveau de la surface de pose une température correspondant à la température cryogénique de fonctionnement de l'amplificateur inférieure à 100 Kelvin, de préférence de l'ordre de 80 Kelvin.

Une telle température permet de garantir un fonctionnement suffisamment amélioré de l'amplificateur qui est réalisé pour être apte à amplifier des signaux radiofréquences sur au moins une plage de fréquences comprise dans les bandes K et Ka entre 18 GHz et 40GHz.

Dans le cas où un vide peu poussé souhaité n'est pas maintenu en permanence dans l'enceinte hermétique du cryostat, l'amplificateur faible bruit comporte une pompe à vide peu poussé, c'est à dire apte à créer une pression dans le cryostat comprise entre la pression à l'extérieure du cryostat et une pression de 0,1millibar, et la pompe est par exemple déclenchée lorsque le réfrigérateur cryogénique est également mis en marche.

Pour un meilleur fonctionnement du réfrigérateur cryogénique et faciliter la dissipation de la chaleur extraite du cryostat par le réfrigérateur, le réfrigérateur cryogénique comporte avantageusement un radiateur extérieur au réfrigérateur cryogénique, pouvant être pourvu d'un ventilateur pour forcer la circulation de l'air entre les ailettes du radiateur.

L'invention concerne également un dispositif de réception de signaux radiofréquences émis par un satellite ou un objet spatial qui met en oeuvre un amplificateur faible bruit suivant l'invention.

Le dispositif de réception comporte un système de commande du réfrigérateur cryogénique qui permet de commuter le réfrigérateur entre d'une part une position arrêt dans laquelle ledit réfrigérateur cryogénique ne produit pas de basse température et dans laquelle l'amplificateur fonctionne à température ambiante suivant un mode dit normal et d'autre part une position marche dans laquelle le dit réfrigérateur cryogénique abaisse la température à laquelle fonctionne l'amplificateur dans un mode dit amélioré.

Pour assurer une commutation optimale entre les deux modes, le système de commande du réfrigérateur cryogénique commute du mode normal au mode amélioré ou du mode amélioré au mode normal en fonction de paramètres reçus ou mesurés, indicateurs d'un niveau de qualité du signal reçu ou susceptible d'être reçu du satellite ou de l'objet spatial ou le cas échéant sur ordre d'un opérateur.

Dans la mesure où les conditions météorologiques sont critiques dans la transmission des signaux des bandes de fréquences considérées, les paramètres reçus ou mesurés indicateurs d'un niveau de qualité du signal caractérisent des conditions météorologiques locales actuelles ou prévues entre le dispositif de réception et le satellite ou l'objet spatial.

Dans une forme préférée de réalisation, un rapport signal sur bruit S/N, généralement disponible au niveau d'un étage de modulation-démodulation du dispositif de réception, de signaux reçus du satellite est utilisé comme au moins un des paramètres indicateurs d'un niveau de qualité du signal.

L'invention concerne également un procédé de réception de signaux radiofréquences, les dits signaux étant émis par un satellite, au moyen d'un dispositif de réception mettant en oeuvre un amplificateur faible bruit pour radiofréquences comportant un mode normal de fonctionnement à température ambiante et un mode amélioré de fonctionnement dans lequel un réfrigérateur cryogénique maintien un amplificateur à une température inférieure à 100 Kelvin, dans lequel procédé :
- le mode amélioré de l'amplificateur faible bruit est activé lorsqu'un rapport signal sur bruit S/N mesuré en mode normal est égal ou inférieur à une première valeur de seuil **S1,** ou que des paramètres mesurés ou reçus conduisent à déterminer que le rapport signal sur bruit S/N, est, ou risque de devenir, inférieur à la première valeur seuil **S1;**
- le mode normal de l'amplificateur faible bruit est activé lorsqu'un rapport signal sur bruit S/N mesuré en mode amélioré est supérieur à une seconde valeur seuil **S2**, ou que des paramètres mesurés ou reçus conduisent à déterminer que le rapport signal sur bruit S/N, est supérieur à la seconde valeur seuil **S2,** la seconde valeur seuil **S2** en mode amélioré correspondant à une valeur du rapport signal sur bruit S/N du même signal reçu dans le mode normal égal ou de préférence supérieure à **S1.**

Ainsi le procédé permet de rendre fiable la liaison radiofréquence en utilisant le mode amélioré que dans des situations présentant un risque identifié d'une interruption de la liaison par une atténuation importante du signal.

Avantageusement suivant le procédé, le mode amélioré est activé temporairement, quelle que soit la valeur du rapport signal sur bruit S/N mesuré, par exemple par l'action d'un opérateur, lorsque le dispositif de réception assure la réception de signaux d'une phase critique telle que la phase de poursuite d'un objet spatial.

Ainsi une dégradation du rapport signal sur bruit non détectée ou non anticipée suffisamment tôt pour activer le mode amélioré depuis le mode normal est sans conséquence sur le bilan de la liaison.

La description de l'invention est faite en référence aux figures qui illustrent schématiquement et de manière non limitative :
- figure 1: un schéma de principe d'un amplificateur faible bruit suivant l'invention ;
- figure 2a: une vue en perspective d'un exemple de réalisation d'un amplificateur faible bruit suivant l'invention;
- figure 2b: une vue en perspective d'un autre exemple de réalisation dans lequel le réfrigérateur cryogénique incorpore un ventilateur et un radiateur;
- figure 3a: une vue en perspective éclatée de l'amplificateur faible bruit et de ses principaux éléments constitutifs; figures 4a et 4b: des vues schématiques de dessus, figure 4a, et de profil, figure 4b, d'un coupleur ;
- figure 3b: une vue intérieur du cryostat correspondant à l'exemple de réalisation de la figure 2b avec un couplage mixte par guide d'onde et câble coaxial de l'amplificateur;
- figures 4a et 4b: une représentation schématique de dessus et de profil d'un coupleur par ligne micro-ruban;
- figure 5: schéma de principe d'un dispositif de réception incorporant un amplificateur faible bruit suivant l'invention.

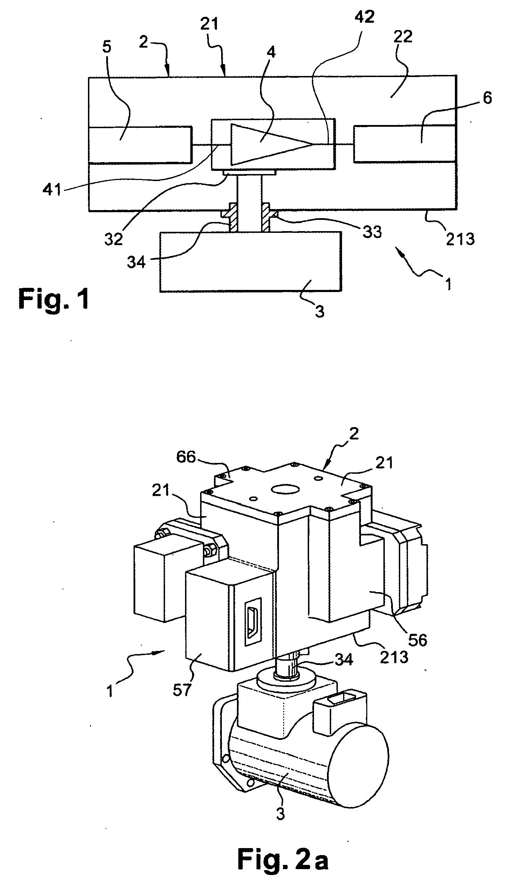

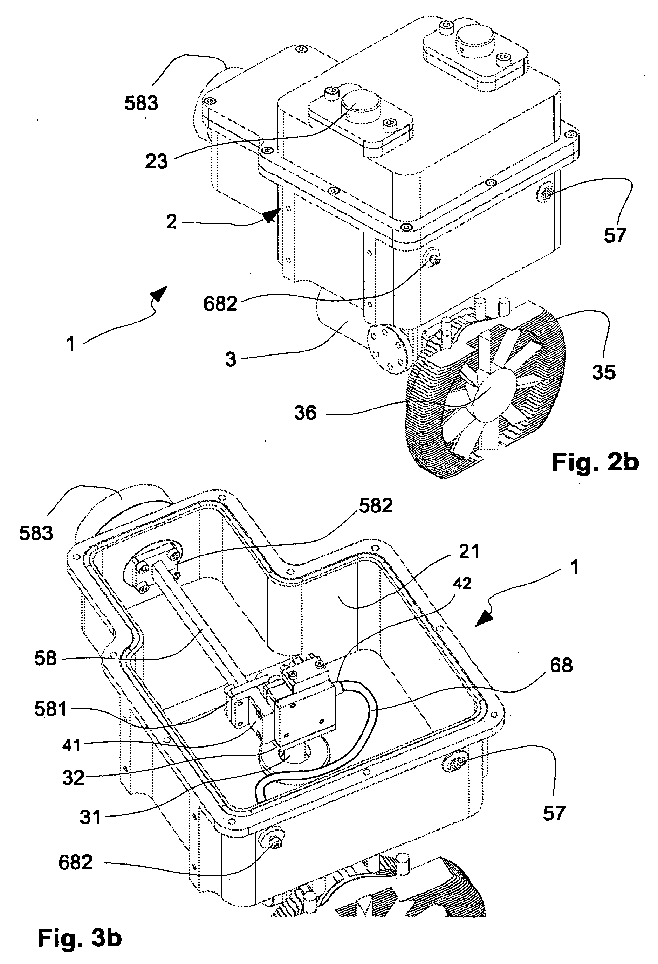

Comme représenté schématiquement sur la figure 1 et en vue perspective sur les figures 2a et 2b d'un amplificateur assemblé, un amplificateur faible bruit 1 suivant l'invention comporte principalement une enceinte isolante ou cryostat 2, à l'intérieur duquel cryostat est enfermé un amplificateur 4 un coupleur d'entrée d'amplificateur 5 raccordé à une entrée 41 de l'amplificateur 4 et un coupleur de sortie d'amplificateur 6 raccordé à une sortie 42 de l'amplificateur 4, et une source froide dite réfrigérateur cryogénique 3 à l'extérieur du cryostat.

L'amplificateur faible bruit 1 est destiné à être mis en oeuvre en environnement atmosphérique dans une chaîne de réception conventionnelle, non représentée, de signaux radiofréquences d'un satellite.

Un doigt froid 31 du réfrigérateur cryogénique 3 traverse une paroi 21 du cryostat de telle sorte qu'une surface de pose 32 dudit doigt froid à l'intérieur du cryostat 2 soit en contact direct au niveau d'une interface avec l'amplificateur 4 ou au moins avec un substrat supportant ledit amplificateur.

Le réfrigérateur cryogénique peut être réalisé à partir de tout type de source de production de froid apte à atteindre des températures inférieures à 100 Kelvin.

De tels réfrigérateurs sont connus, il peut s'agir par exemple d'un générateur de froid fonctionnant en technologie Stirling qui présente les avantages de produire de manière autonome les basses températures recherchées dans un volume réduit.

Dans ce type de solution, il est généralement possible d'évacuer la chaleur extraite du cryostat par le réfrigérateur cryogénique dans l'air ambiant par convection, cette solution pouvant s'avérer très efficace même en cas d'atmosphère très humide sans dommage pour l'amplificateur cryogénique. Avantageusement comme dans l'exemple de réalisation illustré sur la figure 2b, le réfrigérateur cryogénique 3 est pourvu d'un radiateur 35 tel qu'un radiateur à ailettes avantageusement, si l'air environnant n'est pas suffisamment mis en mouvement par d'autres moyens, associé à un ventilateur 36 forçant une circulation d'air pour évacuer efficacement la chaleur.

L'interface du doigt froid 31, totalement inerte, est réalisée dans un matériau bon conducteur de chaleur, par exemple du cuivre ou un alliage à base de cuivre ou encore un autre métal ayant de bonnes propriétés de conduction thermique, et est connecté au réfrigérateur cryogénique 3 de telle sorte qu'il assure un transfert de chaleur par conduction efficace entre le réfrigérateur 3 et l'amplificateur 4.

L'amplificateur 4 est en lui-même un modèle d'amplificateur conventionnel apte à fonctionner aux températures ambiantes et aux basses températures.

Dans l'exemple préféré de réalisation décrit, l'amplificateur 4 est un circuit intégré micro-ondes monolithique, technologie dite MMIC, afin que l'amplificateur 4 ait des dimensions aussi réduites que possible et ainsi limiter les dimensions du cryostat 2 et du réfrigérateur cryogénique 3 nécessaire pour son refroidissement et son maintien à basse température lorsque le réfrigérateur cryogénique est en service.

Non seulement pour améliorer l'efficacité du réfrigérateur cryogénique 3 et en limiter les dimensions et la consommation en énergie lorsqu'il est en fonction, mais aussi pour permettre d'atteindre effectivement les températures recherchées au niveau de l'amplificateur 4, le cryostat 2 et l'agencement des composants à l'intérieur du cryostat sont réalisés afin de limiter les pertes d'énergie thermique.

Pour cela l'enveloppe 21 du cryostat 2 est étanche afin d'isoler un volume intérieur de l'enveloppe par rapport à un espace extérieur au cryostat.

Le cryostat 2 est par exemple réalisé par usinage d'une cavité dans un bloc d'un matériau résistant, par exemple un bloc métallique, ladite cavité étant refermée par un couvercle dont l'étanchéité est assurée par un joint, un joint torique ou un autre type de joint adapté, le but étant de limiter les pertes thermiques entre l'intérieur du cryostat et l'extérieur que provoquerait une circulation de gaz entre ces deux espaces.

Différentes traversées nécessaires au fonctionnement de l'amplificateur sont également réalisées mais de sorte à maintenir l'étanchéité du cryostat 2.

Ainsi l'étanchéité est assurée au niveau de la traversée de la paroi 21 par le doigt froid 31.

Dans un mode préféré de réalisation le doigt froid 31, au moins dans sa partie extérieure au cryostat 2, comporte une enveloppe d'un isolant thermique 34, lequel isolant comporte un épaulement 33 prenant appui sur une face 213 de la paroi traversée du cryostat 2. Un joint placé entre la paroi et ledit épaulement assure à la foi l'étanchéité et une isolation thermique vis à vis de la face 213 pour limiter les pertes de refroidissement de l'amplificateur 4.

Pour les mêmes raisons, le doigt froid 31 traverse la paroi 21 sans contact, l'ouverture dans la face 213 étant pour cela d'une section supérieure à celle du doigt 31, et inférieur à celle de l'épaulement.

L'étanchéité est également assurée par des connecteurs étanches aux niveaux de traversées nécessaires du cryostat 2 pour permettre l'accès des signaux radiofréquences et de signaux continus tels que des tensions d'alimentation et de commande de l'amplificateur 4 et des signaux de surveillance, en particulier de mesure de la température afin de réguler le fonctionnement de l'amplificateur cryogénique.

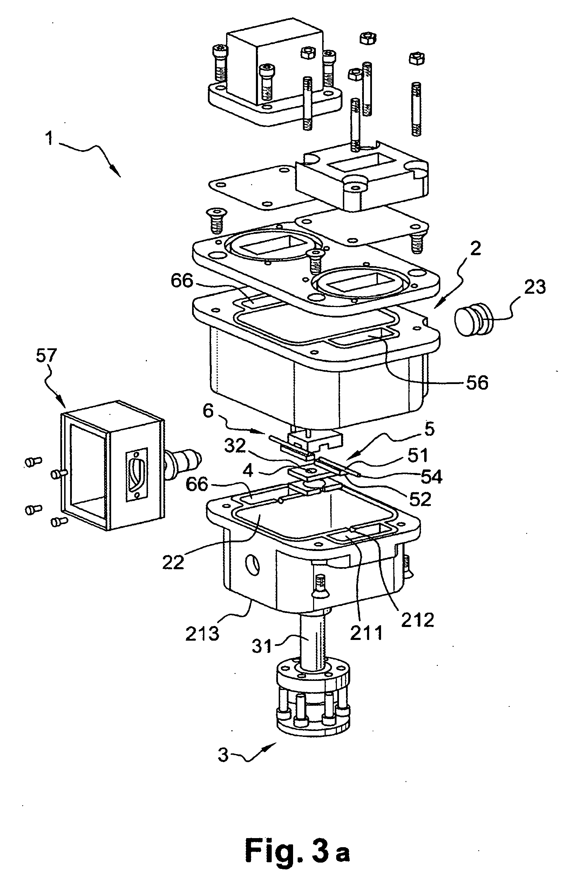

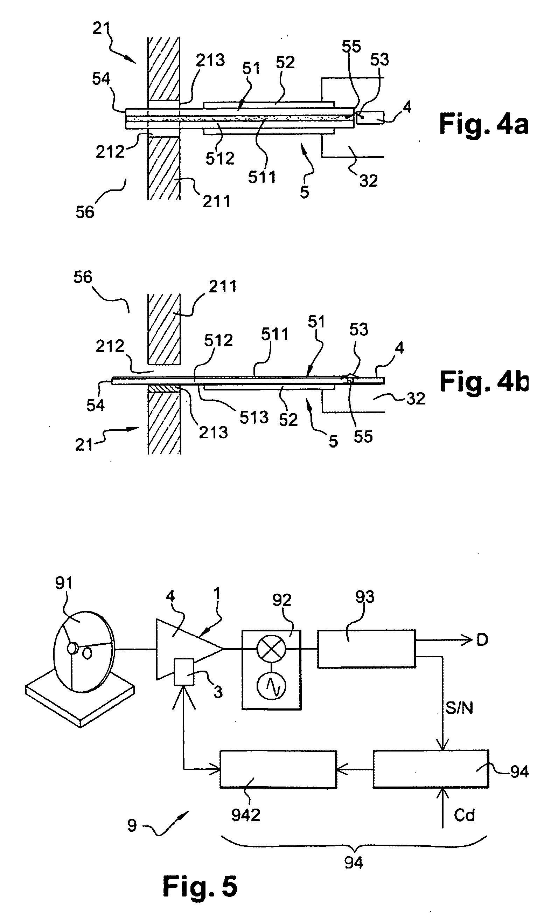

Dans une forme de réalisation, au niveau de l'entrée du signal radiofréquence dans l'amplificateur 4, le coupleur d'entrée 5 est réalisé au moyen d'un élément dit ligne micro-ruban 51 comme illustré sur les figures 3a, 4a et 4b.

La ligne micro-ruban 51 comporte elle-même un ruban étroit en matériau électriquement conducteur, dit micro-ruban 511, formant une piste conductrice solidaire d'une face supérieure d'un film diélectrique mince 512 d'une largeur supérieure à celle dudit micro-ruban 511 et dont une autre face dudit film diélectrique, dite face inférieure, opposée à la face supérieure comporte une couche conductrice mince dite couche métallisée 513 formant un plan de masse électrique pour la ligne micro-ruban 511.

Pour des raisons mécaniques, la ligne micro-ruban est solidaire d'un bras support 52 réalisé dans un matériau diélectrique qui s'étend sensiblement entre un support de l'amplificateur 4, en pratique la surface de pose 32 sur laquelle est placé l'amplificateur 4, et la paroi 21 du cryostat 2, plus précisément au niveau d'une face de la paroi 21 formant une paroi 211 d'un guide d'onde 56.

A une première extrémité 54, dite extrémité libre, la ligne micro-ruban s'étend au-delà du bras support 52 et passe par un orifice ou iris 212 de la paroi du guide d'onde 211 pour pénétrer à l'intérieur du guide d'onde 56.

Au niveau de son passage à travers l'iris 212, la ligne micro-ruban est maintenue en appui, par exemple par collage, sur une semelle 213 d'un matériau hautement diélectrique au niveau de la couche métallisée 513, sans être en contact par ses bords avec les bords de l'iris, l'ouverture de l'iris étant réalisée en fonction des dimensions de la ligne micro-ruban pour obtenir ce résultat.

Par matériau hautement diélectrique, l'homme du métier comprend qu'il s'agit de sélectionner, parmi les matériaux connus pour avoir de bonnes propriétés de permittivité électrique aux fréquences considérées et qui sont acceptables en termes de contraintes techniques et économiques, un des matériaux ayant une grande permittivité.

On comprend que le positionnement et la traversée de la paroi 211 du guide d'onde sont ainsi réalisés sans contact métallique avec la paroi du guide d'onde 211 de la ligne micro-ruban51.

Lorsque l'iris 212 est laissé partiellement ouvert, l'étanchéité recherchée de la cavité 22 peut être assurée par une fenêtre d'un matériau diélectrique dans le guide d'onde 56.

A une extrémité opposée à l'extrémité libre 54, dite extrémité intérieure 55, la ligne micro-ruban s'arrête avant l'amplificateur 4 auquel elle est reliée par un fil d'interconnexion 53.

Le bras support 52, qui soutient la ligne micro-ruban 51 entre le support de l'amplificateur 4 et la paroi 211 du guide d'onde 56, est solidaire du support de l'amplificateur 4 du côté de l'extrémité intérieure de la ligne micro-ruban 51 et est interrompu avant la paroi 211 du guide d'onde 56 afin de ne pas être en contact avec ladite paroi.

En pratique un à deux millimètres séparant l'extrémité interrompue du bras support 52 de la paroi 211 du guide d'onde sont suffisant pour éviter ce contact sans affaiblir la résistance mécanique de la ligne micro-ruban 51.

Un tel agencement du coupleur d'entrée 5 limite au maximum les échanges thermiques de l'amplificateur 4 avec l'extérieur du cryostat 2, par le coupleur 5, qui auraient pour effet de diminuer l'efficacité du refroidissement de l'amplificateur 4 par le réfrigérateur cryogénique 3, et maintient le transfert de la puissance radiofréquence entre le micro-ruban 511 et le guide d'onde 56 avec un minimum de contact physique et de conduction thermique.

Au niveau de la sortie du signal radiofréquence de l'amplificateur 4, le coupleur de sortie 6 est agencé de manière similaire au coupleur d'entrée 5, dans ce cas l'extrémité libre de la ligne micro-ruban traversant la paroi du cryostat correspondant à une paroi d'un guide d'onde 66.

Dans une autre forme de réalisation, les coupleurs d'entrée 5 et de sortie 6 sont réalisés d'une manière similaire au moyen de guides d'ondes à l'intérieur du cryostat 2.

Cette forme de réalisation est illustrée sur la figure 3b dans le cas du coupleur d'entrée 5 au niveau de l'entrée du signal radiofréquence dans l'amplificateur 4, le coupleur d'entrée 5 étant réalisé au moyen d'un guide d'onde 58.

Le guide d'onde 58 est fixé à une extrémité intérieure 581 au niveau de l'entrée 41 de l'amplificateur 4, dans ce cas par une bride du guide d'onde sur un boîtier encapsulant l'amplificateur, et à une extrémité extérieure 582 au niveau d'une traversée de la paroi 21 du cryostat à l'extérieur de laquelle est agencé une interface de raccordement, ou fenêtre guide d'onde 583, à un guide d'onde d'une antenne de réception (non représentée sur la figure 3b).

Le montage du guide d'ondes 58 est réalisé à ses extrémités 581, 582 pour d'une part respecter les contraintes générales d'installation des guides d'ondes en particulier en matière de continuité électrique des parois du guide d'onde et d'autre par afin de respecter les contraintes d'étanchéité recherchée dans la présente application entre l'intérieur du cryostat 2 et l'extérieur du cryostat.

L'étanchéité recherchée avec l'environnement extérieur au cryostat au niveau de l'extrémité extérieure 582 du guide d'onde est obtenue par un montage étanche de la fenêtre guide d'onde sur la paroi du cryostat et par l'obturation de la fenêtre guide d'onde au moyen d'une plaque d'un matériau diélectrique maintenue de manière étanche entre deux parties de la fenêtre guide d'onde qui enserrent ladite plaque en mettant en pression des joints d'étanchéité.

Dans cette forme de réalisation du coupleur d'entrée 5 la performance du couplage sur le plan radioélectrique est de très bonne qualité, mais le guide d'ondes forme entre l'amplificateur 4 refroidi par le doigt froid 31 du réfrigérateur cryogénique 3 et la paroi 21 du cryostat 2 une liaison physique directe dont la conduction thermique est préjudiciable au maintien de la température la plus basse possible au niveau de l'amplificateur 4.

Cette difficulté particulière est résolue en réalisant le guide d'onde 58 dans un matériau métallique ayant des caractéristiques de mauvaise conduction thermique c'est à dire de conductivité thermique inférieure à 50 W/m.K.

De préférence le guide d'onde 58 est réalisé dans un matériaux non oxydable tel qu'un acier inoxydable dont la conductivité thermique est de l'ordre de 16 W/m.K ou un alliage Fer-Nickel à forte teneur en nickel type INVAR®, comportant environ 36% de Nickel, dont la conductivité thermique est de l'ordre de 13 W/m.K, valeurs à comparer à celles de l'aluminium ou du cuivre respectivement de l'ordre de 200 et 350 W/m.K.

La faible conductivité thermique des métaux s'accompagnant d'une conductivité électrique également faible, contraire à l'obtention de bonnes performances d'un guide d'onde et à la continuité électrique entre l'entrée du cryostat 2 et l'entrée 41 de l'amplificateur 4, un dépôt mince d'un matériau à forte conductivité électrique recouvre la surface d'une paroi interne (non visible sur les figures) du guide d'onde 58 de l'amplificateur cryogénique de l'invention.

Un tel matériau est par exemple de l'argent, de conductivité électrique 62 10E6 Siemens/m, du cuivre, de conductivité électrique 58 10E6 Siemens/m, ou encore de l'or, de conductivité électrique 44 10E6 Siemens/m.

D'autres métaux sont également envisageables dont la conductivité électrique est très supérieure à celles de l'acier inoxydable ou de l'INVAR®, ces derniers ayant des conductivités électriques de l'ordre de un 10E6 Siemens/m, mais il convient dans la sélection du matériau à forte conductivité électrique de tenir compte d'autres caractéristiques du matériau telles que sa tenue à la corrosion et son aptitude à être déposé en couche mince de quelques micromètres, de préférence entre 1 et 5 micromètres d'épaisseur, typiquement 3 micromètres, sur le matériau métallique à faible conductivité thermique mis en oeuvre.

Dans une autre forme de réalisation, les coupleurs d'entrée 5 et de sortie 6 sont réalisés de manière similaire au moyen de câbles coaxiaux à l'intérieur du cryostat.

Cette forme de réalisation est illustrée sur la figure 3b dans le cas du coupleur de sortie 6 au niveau de la sortie 42 du signal radiofréquence de l'amplificateur 4, le coupleur de sortie 6 étant réalisé au moyen d'un câble coaxial 68.

Dans cette forme de réalisation le signal de sortie est transmis par un câble coaxial 68 depuis la sortie 42 de l'amplificateur 4 jusqu'à une prise coaxiale 682 traversant de manière étanche la paroi 21 du cryostat.

Par sa structure le câble coaxial 68 en lui-même s'avère suffisamment isolant sur le plan thermique pour ne pas perturber le fonctionnement thermique de l'amplificateur faible bruit 1.

Comme il est compris de la figure 3b, les différentes formes de réalisation des coupleurs d'entrée 5 et de sortie 6 peuvent être combinées en fonction du domaine de fonctionnement et des performances attendues de l'amplificateur faible bruit 1.

En pratique une solution mettant en oeuvre des coupleurs d'entrée et de sortie utilisant des câbles coaxiaux sera de préférence réservée aux fréquences basses de la bande considérée alors qu'une solution mettant en oeuvre des coupleurs d'entrée et de sortie utilisant des guides d'ondes sera préférée dans les cas ou une priorité sera donnée à la diminution des pertes de transmission qui s'avèrent d'autant plus significatives que la fréquence du signal amplifié est élevée.

Dans le mode de réalisation préféré illustré sur la figure 3b, le coupleur d'entrée 5 utilise un guide d'ondes 58 et le coupleur de sortie 6 utilise un câble coaxial 68, solution qui sera acceptable lorsque en pratique la transmission du signal amplifié sera satisfaisante car moins critique que dans le cas du signal d'entrée qui n'a pas encore été amplifié.

Le cryostat 2 détermine donc une cavité étanche 22 dans laquelle est situé l'amplificateur 4.

La cavité étanche est remplie d'un gaz sensiblement à la pression extérieure, c'est à dire que ladite cavité est refermée à la pression ambiante lors de sa fabrication ou lors d'une opération de réparation et aucun vide poussé n'est réalisé dans la cavité dans une étape ultérieure.

Le gaz est par exemple de l'air, de préférence un air sec, ou tout autre gaz neutre sans humidité, par exemple de l'azote ou de l'argon.

Bien que l'amplificateur faible bruit de l'invention puisse être mis en oeuvre en conservant l'intérieur du cryostat 2 à la pression ambiante, un vide peu poussé, c'est à dire correspondant à une pression comprise entre la pression ambiante et 0,1millibar, s'avère bénéfique en diminuant sensiblement les pertes d'énergie thermique sans exiger, lorsque la température est à nouveau abaissée après un fonctionnement à la température ambiante, de réaliser à nouveau le vide.

En outre un tel vide peu poussé est réalisable sans difficulté particulière au moyen d'une pompe d'aspiration à vide primaire, pompe mécanique conventionnelle, contrairement aux vides poussés qui exigent en plus de la pompe à vide primaire de mettre en oeuvre une pompe turbomoléculaire dont les contraintes de mise en oeuvre sont incompatibles avec les objectif opérationnels recherchés pour l'amplificateur faible bruit de l'invention.

Pour tirer parti de cet avantage, la paroi 21 du cryostat comporte un orifice correspondant à une prise d'aspiration sur laquelle est raccordée une telle pompe à vide peu poussé qui est réalisé en usine ou en atelier ou bien qui est réalisé sur demande lorsqu'une telle pompe est relier en permanence à l'amplificateur faible bruit.

Du fait de l'absence de vide poussé dans le cryostat 2, l'étanchéité est beaucoup plus simple à réaliser et le vide est maintenu sans difficulté tant que le cryostat n'est pas ouvert pour une opération d'entretien ou de réparation contrairement aux cas des amplificateurs cryogéniques connus maintenus dans une enceinte sous vide poussé qui doit être entretenu.

Dans un mode préféré de réalisation, la cavité 22 à pression ambiante ou à vide peu poussé est également remplie d'un matériau isolant thermique qui améliore l'isolation en agissant sur les différents modes de dissipation thermique, conduction, convection et rayonnement.

Avantageusement l'isolant thermique remplissant la cavité 22 est un matériau nanostructuré à faible densité tel qu'un matériau nanostructuré réalisé à base de silice SiO2.

Un tel matériau isolant est disponible sous la forme d'un aérogel de silice qui est disponible commercialement sous forme de microbilles ou de feuilles pouvant être déposées en couches. La cavité est par exemple remplie en microbilles grâce à un orifice, non visible sur les dessins, sur une face de l'enceinte étanche, orifice fermé par un bouchon étanche 23 en conditions opérationnelles.

L'amplificateur 4 est ainsi maintenu avec des échanges thermiques minimaux avec l'extérieur, autrement que par le doigt 31 du réfrigérateur cryogénique 3, sans que la cavité 22 du cryostat n'ait besoin d'être soumise à un vide de gaz poussé préalablement au fonctionnement du réfrigérateur.

Une ou des prises étanches 57 sont également agencées sur une face de la paroi 21 du cryostat 2.

Ces prises permettent de raccorder depuis l'extérieur du cryostat 2 les liaisons électriques permettant l'alimentation électrique et la polarisation de l'amplificateur 4, de surveiller le fonctionnement des différents composants et de surveiller la température à l'intérieur du cryostat, par exemple au moyen de sondes thermiques conventionnelles afin de commander l'alimentation du réfrigérateur cryogénique 3.

De par sa conception spécifique, l'amplificateur faible bruit 1 de l'invention comporte deux modes de fonctionnement alternatifs.

Dans un premier mode, dit mode normal, le réfrigérateur cryogénique 3 est à l'arrêt, le cas échéant la pompe à vide peu poussé est également à l'arrêt, et l'amplificateur 4 fonctionne à la température ambiante, c'est à dire la température rencontrée à la surface de la Terre autour de 288 Kelvin en moyenne.

Ce mode normal est en pratique suffisant dans la plupart des situations météorologiques rencontrées en exploitation pour assurer les performances recherchées de la liaison avec le satellite, l'amplificateur 4 étant réalisé à faible bruit pour obtenir dans ces conditions de température un rapport signal sur bruit satisfaisant pour les conditions ordinaires de la liaison.

Dans un second mode, dit mode amélioré, le réfrigérateur cryogénique 3 est en fonction, ainsi que le cas échéant la pompe à vide peu poussé si le cryostat est maintenu connecté à une telle pompe, ce qui ne sera généralement pas nécessaire lorsque le vide peu poussé aura été réalisé en atelier, et assure le refroidissement de l'amplificateur 4 par l'intermédiaire du doigt froid 31 à une température basse inférieure à 100 Kelvin, par exemple 80 Kelvin.

Dans ce second mode, l'amplificateur 4 fonctionne avec un niveau de bruit thermique interne particulièrement faible en raison de la température abaissée et les performances de réceptions sont en mesure d'être maintenues dans des conditions météorologiques défavorables, l'amplificateur 4 bénéficiant alors d'un très faible bruit.

Ce second mode n'est actif, c'est à dire ne consomme de l'énergie et ne s'use, que dans le cas exceptionnel d'une météorologie défavorable, c'est à dire pour la plupart des situations opérationnelles un pourcentage limité du temps de fonctionnement des liaisons qui représente un compromis entre la sensibilité à température ordinaire et les conditions météorologiques moyennes du lieu d'implantation du dispositif de réception, ce qui a pour effet de diminuer la consommation totale de l'amplificateur par rapport à un amplificateur cryogénique conventionnel et en augmente d'autant la durée de vie et la fiabilité limitées par le réfrigérateur cryogénique.

Un dispositif de réception 9, tel que présenté sur la figure 5, mettant en oeuvre un amplificateur faible bruit 1 de l'invention raccordé à une antenne 91 comporte donc des moyens de commande 94 dudit amplificateur faible bruit qui assurent la mise en service et l'arrêt du réfrigérateur cryogénique 3 en fonction d'un niveau de bruit S/N acceptable de l'amplificateur compte tenu de la qualité du signal reçu ou attendu.

Dans un exemple d'un mode de commande, le réfrigérateur cryogénique 3 est mis en service ou arrêté en fonction de la qualité du signal, plus particulièrement du rapport signal sur bruit S/N du signal, rapport S/N généralement disponible dans le dispositif de réception 9 dans lequel est incorporé l'amplificateur faible bruit 1 au niveau d'un étage de modulation-démodulation 93 en sortie duquel sont délivrées les données transmises **D** après une conversion de fréquence assurée par un convertisseur 92.

Lorsque le réfrigérateur cryogénique 3 est à l'arrêt et que le rapport signal sur bruit S/N descend en dessous d'une première valeur seuil **S1** prédéfinie, supérieure à une valeur limite en dessous de laquelle les performances de la transmission serait dégradées en dessous d'un niveau acceptable, c'est à dire entraînant des pertes non admises de données D, les moyens de commande 94 mettent en service le réfrigérateur cryogénique 3 et régulent son fonctionnement afin de maintenir une température contrôlée, par exemple 80 Kelvin, au niveau de l'amplificateur 4.

Lorsque le réfrigérateur cryogénique 3 est en service, les moyens de commande 94 régulent son fonctionnement pour maintenir la température voulue de l'amplificateur 4 tant que le rapport signal sur bruit S/N n'atteint pas, par valeur inférieure, une seconde valeur de seuil **S2** et, lorsque la dite valeur **S2** est atteinte ou dépassée, arrête le fonctionnement du réfrigérateur cryogénique 3.

La seconde valeur de seuil **S2,** qui est considérée lorsque l'amplificateur faible bruit 1 est en mode amélioré, est choisie telle qu'elle correspond une fois l'amplificateur faible bruit 1 en mode normal à un rapport signal sur bruit égal et de préférence supérieur, au moins d'une valeur mesurable, à la première valeur de seuil **S1.**

Les moyens de commande 94 comportent avantageusement des moyens de calculs 941, par exemple des moyens de calculs incorporant un processeur ou un micro-contrôleur, et un contrôleur 942 qui assure l'activation et la désactivation du réfrigérateur cryogénique 3.

Ce choix des seuils **S1** et **S2** permet de réguler le passage entre les modes normal et amélioré avec une hystérésis qui évite un pompage entre les deux modes.

Dans un autre exemple, pouvant être combiné avec l'exemple précédent, d'un mode de commande le réfrigérateur cryogénique 3 est mis en service ou arrêté en fonction de données extérieures **Cd** à la chaîne de réception incorporant l'amplificateur faible bruit 1, par exemple des données météorologiques entre l'antenne 91 et l'objet spatial transmettant des données et ou des informations sur la criticité d'une liaison, permettant d'anticiper un risque de dégradation des qualités de la liaison avec l'objet spatial ou encore des données élaborées à partir d'un signal spécifique émis par l'objet spatial pour mesurer la qualité actuelle de propagation des signaux et définir le mode de fonctionnement de l'amplificateur 1 devant être actif.

Ainsi lorsqu'une liaison est jugée particulièrement critique, le processeur 941 active, sur une instruction **Cd,** un fonctionnement permanent du réfrigérateur cryogénique 3 pour éviter de fait une perte de données **D** dans le cas d'une baisse de qualité du signal même non prévue.

Avantageusement une commande manuelle est prévue de sorte qu'un opérateur soit en mesure de forcer un mode de fonctionnement ou l'autre à sa demande.

Le choix des seuils, et de manière générale des conditions déterminant la mise en service du réfrigérateur cryogénique 3, prend en compte le délai nécessaire pour que la température de l'amplificateur 4 soit descendue à la valeur nominale cryogénique recherchée avant que les conditions de la transmission ne risquent de s'être dégradée à un point tel que des données risqueraient d'être perdues de manière inadmissible si l'amplificateur avait fonctionné à température ambiante ou insuffisamment abaissée.

Le système d'amplification à faible bruit commutable de l'invention permet ainsi d'améliorer la réception des données transmises par un satellite sans perte de performances de la transmission dans un domaine d'utilisation étendu avec un amplificateur de dimensions réduites, par une adaptation en temps réel du bruit interne de l'amplificateur en fonction des conditions de réception.

L'invention ne se limite pas à l'exemple de réalisation décrit, l'homme du métier étant en mesure d'appliquer les principes de l'exemple à d'autres modes de réalisation.

En particulier des composants tels que des filtres ou des oscillateurs qui ont également intérêt à être refroidis dans le mode amélioré peuvent être associés à l'amplificateur pour être refroidis suivant le principe de l'invention.

L'agencement des composants de l'amplificateur faible bruit et la performance de l'isolation thermique qui en découle permettent de réaliser un amplificateur faible bruit pour la réception de signaux radiofréquences suivant deux modes de sensibilités différentes et dont les dimensions sont particulièrement réduites comparées à celles des amplificateurs cryogéniques conventionnels.

En pratique il s'est avéré possible sans développer de technologies extrêmes pour le réfrigérateur cryogénique 3 de réaliser un amplificateur faible bruit à deux modes de fonctionnement conforme à la figure 2 dont les dimensions correspondent à un cube enveloppe pouvant être inférieur à 20 cm d'arête.

## Revendications

1. Amplificateur faible bruit (1) pour dispositif de réception d'un signal radiofréquence d'un satellite ou d'un objet spatial comportant un amplificateur (4) maintenu dans une cavité étanche (22) délimitée par une paroi (21) d'un cryostat (2), et comportant un réfrigérateur cryogénique (3) fixé à l'extérieur dudit cryostat au niveau d'une face (213) de la paroi (21) **caractérisé en ce que** l'amplificateur (4) est:
- maintenu dans la cavité étanche (22) solidaire d'une surface de pose (32) située à l'extrémité d'un doigt froid (31) du réfrigérateur cryogénique (3), ladite surface de pose du doigt froid étant réalisée dans un matériau bon conducteur de la chaleur, ledit doigt froid traversant sans contact direct la face (213) de la paroi (21);
- relié à un coupleur d'entrée (5) au niveau d'une entrée (41) de l'amplificateur (4) et un coupleur de sortie (6) au niveau d'une sortie (42) de l'amplificateur (4), lesdits coupleurs d'entrée et de sortie traversant chacun la paroi (21) du cryostat (2);
- fonctionnel d'une part à une température ambiante autour de 288 Kelvin et d'autre part au moins à une température cryogénique déterminée très inférieure à la température ambiante;
et **caractérisé en ce que** la cavité étanche (22) du cryostat (2) contient, au moins pendant le fonctionnement à température cryogénique, un gaz à une pression comprise entre une pression voisine de la pression à l'extérieur du cryostat et une pression d'environ 0,1 millibar.

2. Amplificateur faible bruit suivant la revendication 1 dans lequel le coupleur d'entrée (5) comporte un guide d'onde (58) fixé à une extrémité intérieure (581) au niveau de l'entrée (41) de l'amplificateur (4) et à une extrémité extérieure (582) au niveau d'une traversée étanche de la paroi (21) du cryostat (2) sans discontinuité électrique entre l'entrée de l'amplificateur (4) et une interface de raccordement d'une antenne de réception au niveau d'une fenêtre guide d'ondes (583), ou bien dans lequel le coupleur d'entrée (5) comporte un câble coaxial entre l'entrée (41) de l'amplificateur (4) et une prise coaxiale traversant de manière étanche la paroi (21) du cryostat.

3. Amplificateur faible bruit suivant la revendication 1 ou la revendication 2 dans lequel le coupleur de sortie (6) comporte un guide d'ondes fixé à une extrémité intérieure (581) au niveau de l'entrée (41) de l'amplificateur (4) et à une extrémité extérieure (582) au niveau d'une traversée étanche de la paroi (21) du cryostat (2) sans discontinuité électrique entre l'entrée de l'amplificateur (4) et une interface de raccordement d'une antenne de réception au niveau d'une fenêtre guide d'ondes (583) ou bien dans lequel le coupleur de sortie (6) comporte un câble coaxial entre la sortie (42) de l'amplificateur (4) et une prise coaxiale (682) traversant de manière étanche la paroi (21) du cryostat.

4. Amplificateur faible bruit suivant la revendication 2 ou la revendication 3 comportant un ou des guides d'ondes dans lequel ledit ou lesdits guides d'ondes sont constitués principalement d'un matériau métallique à faible conductivité thermique, de préférence inférieure à 50W/m.K, tel qu'un acier inoxydable ou un alliage fer-nickel comportant environ 36% de nickel, et comporte au niveau d'une surface intérieure de la cavité du guide d'onde un dépôt mince d'un matériau de conductivité électrique élevée, de préférence supérieure à 40 10E6 Siemens/m, tel que de l'argent, du cuivre ou de l'or.

5. Amplificateur faible bruit suivant la revendication 1 dans lequel au moins un coupleur (5,6) traverse la paroi (21) par une ouverture ou iris (212) au niveau de la paroi (211) d'un guide d'ondes (56, 66) et:
- comporte une ligne micro-ruban (51) comportant :
- un micro-ruban (511) en matériau électriquement conducteur ;
- ledit micro-ruban (511) étant solidaire d'un film diélectrique mince (512) sur une face supérieure dudit film diélectrique ;
- ledit film diélectrique mince (512) comportant une couche métallisée (513) sur une face inférieure opposée à la face supérieure et formant un plan de masse électrique ;
- ladite ligne micro-ruban (51) s'étendant au niveau d'une première extrémité, dite extrémité libre (54), dans le guide d'onde (56, 66) en traversant la paroi (211) du guide d'onde par l'iris (212), sans contact métallique entre la ligne micro-ruban (51) et la paroi (211) du guide d'onde ;
- ladite ligne micro-ruban (51) s'étendant au niveau d'une seconde extrémité, dite extrémité intérieure (55), à l'opposé de l'extrémité libre (54) sur la ligne micro-ruban (51), jusqu'à proximité de l'amplificateur (4) sans contact direct avec ledit amplificateur ;
- ladite ligne micro-ruban (51) étant dépourvue de la couche métallisée (513) dans la partie de ladite ligne micro-ruban (51) située à l'intérieur du guide d'onde (56, 66)

6. Amplificateur faible bruit suivant la revendication 5 dans lequel la ligne micro-ruban (51) est solidaire d'un bras support (52), ledit bras support (52) étant lui-même solidaire d'un support de l'amplificateur (4) à proximité de l'extrémité intérieure (55) de la ligne micro-ruban, ledit bras support (52) étant interrompu du côté de l'extrémité libre (54) de la ligne micro-ruban (51) avant ladite extrémité libre de telle sorte à être maintenu proche de, mais sans contact avec, la paroi (211) du guide d'onde.

7. Amplificateur faible bruit suivant l'une des revendications précédentes dans lequel la cavité étanche (22) est remplie d'un matériau isolant thermique.

8. Amplificateur faible bruit suivant la revendication 7 dans lequel le matériau isolant thermique est un matériau nanostructuré à base de silice sous forme d'aérogel.

9. Amplificateur faible bruit suivant l'une des revendications précédentes dans lequel le réfrigérateur cryogénique délivre au niveau de la surface de pose (32) une température correspondant à la température cryogénique de fonctionnement de l'amplificateur (4) inférieure à 100 Kelvin, de préférence de l'ordre de 80 Kelvin.

10. Amplificateur faible bruit suivant l'une des revendications précédentes comportant une pompe à vide peu poussé correspondant à une pression résultante dans le cryostat (2) comprise entre la pression à l'extérieure du cryostat et une pression de 0,1millibar.

11. Dispositif de réception (9) de signaux radiofréquences émis par un satellite ou un objet spatial, ledit dispositif de réception comportant un amplificateur faible bruit (1) suivant l'une des revendications précédentes, ledit dispositif de réception étant **caractérisé en ce qu'**il comporte un système de commande (94) du réfrigérateur cryogénique (3) permettant de commuter entre d'une part une position arrêt dans laquelle ledit réfrigérateur cryogénique ne produit pas de basse température et dans laquelle l'amplificateur (4) fonctionne à température ambiante suivant un mode dit normal et d'autre part une position marche dans laquelle le dit réfrigérateur cryogénique abaisse la température à laquelle fonctionne l'amplificateur (4) dans un mode dit amélioré.

12. Dispositif de réception de signaux radiofréquences suivant la revendication 11 dans lequel le système de commande (94) du réfrigérateur cryogénique (3) commute du mode normal au mode amélioré ou du mode amélioré au mode normal en fonction de paramètres reçus ou mesurés indicateurs d'un niveau de qualité du signal reçu ou susceptible d'être reçu du satellite ou de l'objet spatial.

13. Dispositif de réception de signaux radiofréquences suivant la revendication 12 dans lequel les paramètres reçus ou mesurés indicateurs d'un niveau de qualité du signal caractérisent des conditions météorologiques locales actuelles ou prévues entre ledit dispositif de réception et le satellite et ou d'un rapport signal sur bruit S/N de signaux reçus du satellite ou de l'objet spatial est utilisé comme au moins un des paramètres indicateurs d'un niveau de qualité du signal.

14. Procédé de réception de signaux radiofréquences, les dits signaux étant émis par un satellite ou un objet spatial, au moyen d'un dispositif de réception mettant en oeuvre un amplificateur faible bruit (1) pour radiofréquences comportant un mode normal de fonctionnement à température ambiante et un mode amélioré de fonctionnement dans lequel un réfrigérateur cryogénique (3) maintien un amplificateur (4) à une température inférieure à 100 Kelvin, dans lequel procédé :
- le mode amélioré de l'amplificateur faible bruit (1) est activé lorsqu'un rapport signal sur bruit S/N mesuré en mode normal est égal ou inférieur à une première valeur de seuil **S1,** ou que des paramètres mesurés ou reçus conduisent à déterminer que le rapport signal sur bruit S/N, est, ou risque de devenir, inférieur à la première valeur seuil **S1**;
- le mode normal de l'amplificateur faible bruit (1) est activé lorsqu'un rapport signal sur bruit S/N mesuré en mode amélioré est supérieur à une seconde valeur seuil **S2,** ou que des paramètres mesurés ou reçus conduisent à déterminer que le rapport signal sur bruit S/N, est supérieur à la seconde valeur seuil **S2,** la seconde valeur seuil **S2** en mode amélioré correspondant à une valeur du rapport signal sur bruit du même signal reçu dans le mode normal égal ou de préférence supérieure à **S1.**

15. Procédé de réception de signaux radiofréquences suivant la revendication 22 dans lequel le mode amélioré de l'amplificateur faible bruit (1) est activé, indépendamment de la valeur du rapport signal sur bruit S/N, lorsque le dispositif de réception assure la réception de signaux d'une phase de poursuite de l'objet spatial.

## Patentansprüche

1. Verstärker (1) mit geringem Rauschen für eine Vorrichtung zum Empfangen eines Hochfrequenzsignals von einem Satelliten oder einem Weltraumobjekt, der einen Verstärker (4) umfasst, der in einem dichten Hohlraum (22) gehalten wird, der durch eine Wand (21) eines Kryostaten (2) begrenzt ist und einen außerhalb des Kryostaten auf Höhe einer Seite (213) der Wand (21) befestigten Tiefsttemperaturkälteerzeuger (3) enthält, **dadurch gekennzeichnet, dass** der Verstärker (4):
- in dem dichten Hohlraum (22) in fester Verbindung mit einer Abstelloberfläche (32), die sich am Ende eines kalten Fingers (31) des Tiefsttemperaturkälteerzeugers (3) befindet, gehalten wird, wobei die Abstelloberfläche des kalten Fingers aus einem gut wärmeleitenden Material verwirklicht ist, wobei der kalte Finger die Seite (213) der Wand (21) ohne direkten Kontakt durchquert;
- mit einem Eingangskoppler (5) auf Höhe eines Eingangs (41) des Verstärkers (4) und mit einem Ausgangskoppler (6) auf Höhe eines Ausgangs (42) des Verstärkers (4) gekoppelt ist, wobei die Eingangs- und Ausgangskoppler jeweils die Wand (21) des Kryostaten (2) durchqueren;
- einerseits bei einer Umgebungstemperatur um 288 Kelvin und andererseits wenigstens bei einer bestimmten Tiefsttemperatur, die viel niedriger als die Umgebungstemperatur ist, arbeitet;
und **dadurch gekennzeichnet, dass** der dichte Hohlraum (22) des Kryostaten (2) wenigstens während des Betriebs auf Tiefsttemperatur ein Gas mit einem Druck enthält, der zwischen einem Druck in der Nähe des Drucks der äußeren Umgebung des Kryostaten und einem Druck von etwa 0,1 Millibar liegt.

2. Verstärker mit geringem Rauschen nach Anspruch 1, wobei der Eingangskoppler (5) einen Wellenleiter (58) umfasst, der mit einem inneren Ende (581) auf Höhe des Eingangs (41) des Verstärkers (4) befestigt ist und mit einem äußeren Ende (582) auf Höhe eines dichten Durchgangs der Wand (21) des Kryostaten (2) ohne elektrische Unterbrechung zwischen dem Eingang des Verstärkers (4) und einer Schnittstelle für den Anschluss einer Empfangsantenne auf Höhe eines Wellenleiterfensters (583) befestigt ist, oder wobei der Eingangskoppler (5) ein Koaxialkabel zwischen dem Eingang (41) des Verstärkers (4) und einem Koaxialstecker, der die Wand (21) des Kryostaten dicht durchquert, umfasst.

3. Verstärker mit geringem Rauschen nach Anspruch 1 oder Anspruch 2, wobei der Ausgangskoppler (6) einen Wellenleiter umfasst, der mit einem inneren Ende (581) auf Höhe des Eingangs (41) des Verstärkers (4) und mit einem äußeren Ende (582) auf Höhe eines dichten Durchgangs der Wand (21) des Kryostaten (2) ohne elektrische Unterbrechung zwischen dem Eingang des Verstärkers (4) und einer Schnittstelle für den Anschluss einer Empfangsantenne auf Höhe eines Wellenleiterfensters (583) befestigt ist, oder wobei der Ausgangskoppler (6) ein Koaxialkabel zwischen dem Ausgang (42) des Verstärkers (4) und einem Koaxialstecker (682), der die Wand (21) des Kryostaten dicht durchquert, umfasst.

4. Verstärker mit geringem Rauschen nach Anspruch 2 oder Anspruch 3, der einen oder mehrere Wellenleiter umfasst, wobei der eine oder die mehreren Wellenleiter hauptsächlich aus einem Metallmaterial mit geringer Wärmeleitfähigkeit, vorzugsweise kleiner als 50 W/mK, etwa Edelstahl oder eine Eisen-Nickel-Legierung, die etwa 36 % Nickel enthält, gebildet sind, und auf Höhe einer inneren Oberfläche des Wellenleiterhohlraums eine dünne Ablagerung eines Materials mit hoher elektrischer Leitfähigkeit, vorzugsweise größer als 40 10⁶ Siemens/m, etwa Silber, Kupfer oder Gold, aufweist.

5. Verstärker mit geringem Rauschen nach Anspruch 1, wobei wenigstens ein Koppler (5, 6) die Wand (21) durch eine Öffnung oder Iris (212) auf Höhe der Wand (211) eines Wellenleiters (56, 66) durchquert und:
- eine Mikrostreifenleitung (51) umfasst, die ihrerseits umfasst:
- einen Mikrostreifen (511) aus einem elektrisch leitenden Material;
- wobei der Mikrostreifen (511) mit einer dielektrischen Dünnschicht (512) auf einer Außenseite der dielektrischen Dünnschicht fest verbunden ist;
- wobei die dielektrische Dünnschicht (512) auf einer Unterseite gegenüber der Oberseite eine metallisierte Schicht (513) aufweist, die eine elektrische Masseebene bildet;
- wobei sich die Mikrostreifenleitung (51) auf Höhe eines ersten Endes, dem so genannten freien Ende (54), in den Wellenleiter (56, 66) erstreckt und dabei die Wand (211) des Wellenleiters durch die Iris (212) ohne Metallkontakt zwischen der Mikrostreifenleitung (51) und der Wand (211) des Wellenleiters durchquert;
- wobei sich die Mikrostreifenleitung (51) auf Höhe eines zweiten Endes, dem so genannten inneren Ende (55), gegenüber dem freien Ende (54) auf der Mikrostreifenleitung (51) bis in die Umgebung des Verstärkers (4) ohne direkten Kontakt mit dem Verstärker erstreckt;
- wobei die Mikrostreifenleitung (51) die metallisierte Schicht (513) in einem Teil der Mikrostreifenleitung (51), der sich innerhalb des Wellenleiters (56, 66) befindet, nicht aufweist.

6. Verstärker mit geringem Rauschen nach Anspruch 5, wobei die Mikrostreifenleitung (51) mit einem Tragarm (52) fest verbunden ist, wobei der Tragarm (52) seinerseits mit einem Träger des Verstärkers (4) in der Nähe des inneren Endes (55) der Mikrostreifenleitung fest verbunden ist, wobei der Tragarm (52) auf Seiten des freien Endes (54) der Mikrostreifenleitung (51) vor dem freien Ende unterbrochen ist, derart, dass er in der Nähe der Wand (211) des Wellenleiters, jedoch ohne Kontakt mit dieser Wand (211) gehalten wird.

7. Verstärker mit geringem Rauschen nach einem der vorhergehenden Ansprüche, wobei der dichte Hohlraum (22) mit einem wärmeisolierenden Material gefüllt ist.

8. Verstärker mit geringem Rauschen nach Anspruch 7, wobei das wärmeisolierende Material ein Material mit Nanostruktur auf Siliciumoxidbasis in Form eines Aerogels ist.

9. Verstärker mit geringem Rauschen nach einem der vorhergehenden Ansprüche, wobei der Tiefsttemperaturkälteerzeuger auf Höhe der Abstelloberfläche (32) eine Temperatur bereitstellt, die der Tiefsttemperatur für den Betrieb des Verstärkers (4) von weniger als 100 Kelvin, vorzugsweise in der Größenordnung von 80 Kelvin, entspricht.

10. Verstärker mit geringem Rauschen nach einem der vorhergehenden Ansprüche, der eine Vakuumpumpe mit geringem Schub umfasst, der einem resultierende Druck in dem Kryostaten (2) entspricht, der zwischen dem Druck der äußeren Umgebung des Kryostaten und einem Druck von 0,1 Millibar liegt.

11. Vorrichtung (9) für den Empfang von Hochfrequenzsignalen, die von einem Satelliten oder einem Weltraumobjekt ausgesendet werden, wobei die Empfangsvorrichtung einen Verstärker (1) mit geringem Rauschen nach einem der vorhergehenden Ansprüche umfasst, wobei die Empfangsvorrichtung **dadurch gekennzeichnet ist, dass** sie ein System (94) für die Steuerung des Tiefsttemperaturkälteerzeugers (3) umfasst, das ermöglicht, einerseits zwischen einer Halteposition, in der der Tiefsttemperaturkälteerzeuger keine niedrige Temperatur erzeugt und in der der Verstärker (4) bei Umgebungstemperatur in einer so genannten normalen Betriebsart arbeitet, und andererseits einer Betriebsposition, in der der Tiefsttemperaturkälteerzeuger auf die Temperatur senkt, bei der der Verstärker (4) in einer so genannten verbesserten Betriebsart arbeitet, umzuschalten.

12. Vorrichtung für den Empfang von Hochfrequenzsignalen nach Anspruch 11, wobei das Steuersystem (94) des Tiefsttemperaturkälteerzeugers (3) von der normalen Betriebsart in die verbesserte Betriebsart oder von der verbesserten Betriebsart in die normale Betriebsart als Funktion von empfangenen oder gemessenen Parametern umschaltet, die ein Qualitätsniveau des Signals angeben, das von dem Satelliten oder dem Weltraumobjekt empfangen wird oder empfangen werden kann.

13. Vorrichtung für den Empfang von Nochfrequenzsignalen nach Anspruch 12, wobei die empfangenen oder gemessenen Parameter, die ein Qualitätsniveau des Signals angeben, die aktuellen lokalen oder zwischen der Empfangsvorrichtung und dem Satelliten herrschenden meteorolgischen Bedingungen kennzeichnen und/oder wobei ein Rauschabstand S/N der von dem Satelliten oder dem Weltraumobjekt empfangenen Signale wenigstens als einer der Parameter verwendet wird, die ein Qualitätsniveau des Signals angeben.

14. Verfahren zum Empfangen von Hochfrequenzsignalen, wobei die Signale von einem Satelliten oder einem Weltraumobjekt ausgesendet werden, mittels einer Empfangsvorrichtung, die einen Verstärker (1) mit geringem Rauschen für Hochfrequenzen verwendet, der eine normale Betriebsart bei Umgebungstemperatur und eine verbesserte Betriebsart, in der ein Tiefsttemperaturkälteerzeuger (3) einen Verstärker (4) auf einer Temperatur von weniger als 100 Kelvin hält, aufweist, wobei in dem Verfahren:
- die verbesserte Betriebsart des Verstärkers (1) mit geringem Rauschen aktiviert wird, wenn ein Rauschabstand S/N, der in der normalen Betriebsart gemessen wird, gleich oder kleiner als ein erster Schwellenwert **S1** ist oder wenn die gemessenen oder empfangenen Parameter dazu führen, festzustellen, dass der Rauschabstand S/N kleiner als der erste Schwellenwert **S1** ist oder die Gefahr besteht, dass er es wird;
- die normale Betriebsart des Verstärkers (1) mit geringem Rauschen aktiviert wird, wenn ein Rauschabstand S/N, der in der verbesserten Betriebsart gemessen wird, größer als ein zweiter Schwellenwert **S2** ist oder wenn die gemessenen oder empfangenen Parameter dazu führen, dass bestimmt wird, dass der Rauschabstand S/N größer als der zweite Schwellenwert **S2** ist, wobei der zweite Schwellenwert **S2** in der verbesserten Betriebsart einem Wert des Rauschabstands desselben Signals, das in der normalen Betriebsart empfangen wird, entspricht oder vorzugsweise größer als **S1** ist.

15. Verfahren zum Empfangen von Hochfrequenzsignalen nach Anspruch 22, wobei die verbesserte Betriebsart des Verstärkers (1) mit geringem Rauschen unabhängig von dem Wert des Rauschabstandes S/N aktiviert wird, wenn die Empfangsvorrichtung den Empfang von Signalen einer Zielverfolgungsphase des Weltraumobjekts sicherstellt.

## Claims

1. A low noise amplifier device (1) for receiving a radio frequency signal from a satellite or a space object comprising an amplifier (4) kept in a sealed chamber (22) defined by a wall (21) of a cryostat (2), and comprising a cryogenic cooler (3) attached to the exterior of the cryostat at a face (213) of the wall (21) wherein the amplifier (4) is:
○ Maintained in the sealed chamber (22) secured to a mounting surface (32) located at the end of a cold finger (31) of the cryogenic cooler (3), of which the mounting surface of the cold finger is made of a material with good heat conductivity, the cold finger traversing without direct contact the face (213) of the wall (21)
○ Connected to an input coupler (5) at an input (41) of the amplifier (4) and an output coupler (6) at an output (42) of the amplifier (4), the said input coupler and output coupler traverse the wall (21) of the cryostat (2)
○ Functioning on the one hand at an ambient temperature around 288 Kelvin and the other at a cryogenic temperature well below room temperature and wherein the sealed chamber (22) of the cryostat (2) contains, a gas at a pressure between the pressure outside the cryostat and a pressure of approximately 0.1 millibar at least during operation mode at cryogenic temperature.

2. A low noise amplifier according to Claim 1, wherein the input coupler (5) comprises a waveguide (58) attached to an inner end (581) at the input (41) of the amplifier (4) and to an outer end (582) in a sealed port in the wall (21) of the cryostat (2) without electrical discontinuity between the input of the amplifier (4) and an interface for connecting a receiving antenna to a waveguide window (583), or wherein the input coupler (5) comprises a coaxial cable between the input (41) of the amplifier (4) and an air-tight sealed coaxial jack traversing through the wall (21) of the cryostat.

3. A low noise amplifier according to Claim 1 or Claim 2, wherein the output coupler (6) comprises a waveguide attached to an inner end (581) at the input (41) of the amplifier (4) and to an outer end (582) in a sealed port in the wall (21) of the cryostat (2) without electrical discontinuity between the input of the amplifier (4) and an interface for connecting a receiving antenna to a waveguide window (583), or wherein the output coupler (6) includes a coaxial cable between the output (42) of the amplifier (4) and an air-tight sealed coaxial jack (682) traversing through the wall (21) of the cryostat.

4. A low noise amplifier according to Claim 2 and Claim 3, comprising one or more waveguides in which said one or more waveguides consist primarily of a metal material with low thermal conductivity, preferably less than 50W/m.K, like stainless steels or iron-nickel alloys containing approximately 36% nickel, and includes at on the inner surface of the cavity of the waveguide a thin deposit of a material of high electrical conductivity, preferably greater than 40×10⁶ Siemens/m, like silver, copper or gold.

5. A low noise amplifier according to Claim 1, wherein at least one coupler (5, 6) traverses through the wall (21) through an iris (212) at the wall (211) of a waveguide (56, 66) and:
- includes a microstrip line (51) comprising:
- a micro-strip (511) of an electrically conductive material
- said microstrip (511) being attached on an upper face of a thin dielectric plate (512)
- said thin dielectric plate (512) having a metallized layer (513) on a lower face opposed to the upper face and forming an electrical ground plane
- the microstrip line (51) extending at a first end, referred to as the free end (54), into the waveguide (56, 66) across the wall (211) of the waveguide through the iris (212), without metal contact between the microstrip line (51) and the wall (211) of the waveguide
- the microstrip line (51) extending at a second end, referred to as the inner end (55) opposite to the free end (54), up to near the amplifier (4) with no direct contact with the amplifier
- the microstrip line (51) being devoid of the metallized layer (513) along the portion of the microstrip line (51) that is located inside the waveguide (56, 66).

6. A low noise amplifier according to Claim 5 in which the microstrip line (51) is secured to a support arm (52), said support arm being secured to a support of the amplifier (4) near the inner end (55) of the microstrip line, said support arm (52) stopping prior to the free end (54) of the microstrip line (51) so as to be kept close to, but not in contact with the wall (211) of the waveguide.

7. A low noise amplifier according to one of the preceding claims in which the sealed chamber (22) is filled with a thermally insulating material.

8. A low noise amplifier of Claim 7 wherein the thermal insulating material is a nanostructured material based on silica Aerogels.

9. A low noise amplifier according to the preceding claims, wherein the cryogenic cooler produces a temperature corresponding to the cryogenic temperature of operation of the amplifier (4) below 100 Kelvin, or preferably around 80 Kelvin at the level of the mounting surface (32).

10. A low noise amplifier according the preceding claims comprising a pump for low vacuum, resulting in a pressure in the cryostat (2) between the pressure outside the cryostat and a pressure of 0.1 mbar.

11. A reception device (9) of RF signals emitted by a satellite or a space object, comprising a low noise amplifier (1) according to one of the preceding claims, wherein the reception device includes a control system (94) for the cryogenic cooler (3) to switch the cooler between an off state where the cooler does not produce a low temperature and where the amplifier (4) operates in a normal mode at room temperature, and an on state in which the cryogenic cooler lowers the temperature at which the amplifier (4) operates in an enhanced mode.

12. A device for receiving radio frequency signals as in Claim 11, wherein the control system (94) of the cryogenic cooler (3) switches from normal mode to enhanced mode or from enhanced mode to normal mode according to parameters, received or measured, consistent with a signal reception quality, or likely to be received from the satellite or space object.

13. A device for receiving radio frequency signals as in Claim 12, wherein the received or measured parameters indicators of signal quality level characterize the local weather conditions, existing or expected, between the receiving device and the satellite and or the signal to noise ratio S/N from signals received from the satellite or space object is used as at least one of the parameters indicative of a signal quality level.

14. A process for receiving radio frequency signals, emitted by a satellite or a space object by means of a receiving device implementing a low noise amplifier (1) for radio frequencies, with a normal operating mode at room temperature and an enhanced mode of operation in which a cryogenic cooler (3) maintains an amplifier (4) at temperatures below 100 Kelvin, wherein:
○ the enhanced mode of the low noise amplifier (1) is activated when a signal to noise ratio S/N measured in normal mode is equal to or less than a first threshold value **S1,** or when parameters measured or received lead to determine the signal to noise ratio S/N is or may become less than the first threshold value **S1**;
○ the normal mode of the low noise amplifier (1) is activated when a signal to noise ratio S/N measured whilst in enhanced mode is greater than a second threshold value **S2,** or when parameters measured or received lead to determine the ratio signal to noise S/N is greater than the second threshold value **S2,** the second threshold value **S2** in enhanced mode corresponding to a value of signal to noise ratio of the same signal strength received in the normal mode, equal to or preferably greater than **S1.**

15. Process for receiving radio frequency signals of Claim 14 wherein the enhanced mode of the low noise amplifier (1) is activated, regardless of the value of the signal to noise ratio S/N, where the receiving device assures the reception of signals during continuous tracking of a space object.
